Europäisches Patentamt

European Patent Office

Office européen des brevets

(11) Publication number: **0 336 235**
**A2**

## EUROPEAN PATENT APPLICATION

(21) Application number: **89105264.9**

(51) Int. Cl.⁴: **G01V 9/04** , **H03K 17/968**

(22) Date of filing: **23.03.89**

(30) Priority: **06.04.88 JP 84592/88**

(43) Date of publication of application:
**11.10.89 Bulletin 89/41**

(84) Designated Contracting States:
**AT BE CH DE ES FR GB IT LI NL SE**

(71) Applicant: **Schaltbau Gesellschaft mbH**
**Klausenburger Strasse 6**
**D-8000 München 80(DE)**

(72) Inventor: **Ono, Shoichi**
**No. 21-17 Takashima 1-chome**
**Suwa-shi Nagano(JP)**
Inventor: **Kobayashi, Atsuhito**
**No. 21-17 Takashima 1-chome**
**Suwa-shi Nagano(JP)**

(74) Representative: **Patentanwälte Grünecker,**
**Kinkeldey, Stockmair & Partner**
**Maximilianstrasse 58**
**D-8000 München 22(DE)**

(54) **Light identifying system.**

(57) A light identifying system, comprising:
a photoelectric conversion unit for receiving a light
from a light emitting part on a light receiving part,
and generating a light reception signal in magnitude
according to a quantity of the received light;
a peak holding circuit having a time constant large
enough as compared with a lighting time interval of
said light emitting part, and holding a peak value of
said light reception signal inputted therefrom on said
time constant;
a comparator for inputting the peak value held by
the peak holding circuit, and comparing it with said
light reception signal as a threshold.

FIG.1

# LIGHT IDENTIFYING SYSTEM

This invention relates to a light identifying system used on photoelectric switch, measuring apparatus and others for identifying whether or not light from a light emitting part is received.

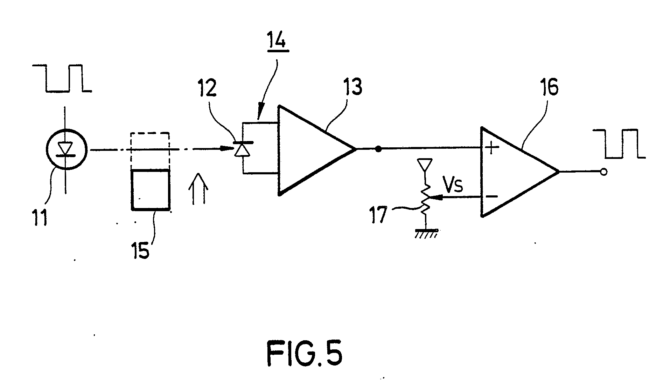

A prior art light identifying circuit will be described with reference to Fig. 5. In the drawing, a reference numeral 11 denotes a light emitting part, 12 denotes a light receiving part, both being disposed opposite each other. When used as an optical switch, an object (moving member) 15 is provided between the light emitting part 11 and the light receiving part 12, and a light from the light emitting part 11 is received by the light receiving part 12 or intercepted according to its move. A light emitting element known as luminous on an electrical signal impressed thereto is used for the light emitting part 11, and a light receiving element known as generating an electrical signal in magnitude according to a quantity of received light is used for the light receiving part 12.

The aforementioned electrical signal or a light reception signal is amplified by an amplifier 13. A combination of the light receiving part 12 and the amplifier 13 is called a photoelectric conversion part 14.

A reference numeral 16 denotes a comparator, wherein a voltage set by a resistance 17, or a threshold is inputted to (-) side input end, which is compared with the light reception signal from the photoelectric conversion unit 14 which is impressed to ( + ) side input end.

Then, a condensing lens is disposed on the front of the light emitting part 11 and the light receiving part 12, which will be described hereinlater.

In the aforementioned construction, the light emitting part 11 is supplied with a pulse signal as illustrated and emits a pulsating light according to the signal. If the object 15 is not present at an intercepting position, the light reaches the light receiving part 12, where it is subjected to a photoelectric conversion, and then generated as a light reception·signal from the photoelectric conversion unit 14. It is then compared with a threshold Vs by the comparator 16, and the result is generated therefrom. That is, if the object 15 is not present at the intercepting position, then a pulse signal synchronized with an incoming signal to the light emitting part 11 is generated. On the other hand, when the object 15 is present at the intercepting position, a signal of the comparator 16 remains as "L" level.

Thus, whether or not the object 15 is present at a predetermined position is identified on an outgoing signal of the comparator 16.

(Problem to be Solved by the Invention)

The aforementioned comparator 16 has an output inverted according to whether or not a magnitude of the light reception signal is at the preset threshold Vs or over. The threshold is fixed on the prior art system, therefore when a quantity of emitted light of the light emitting part 11 decreases due to a secular change, and a quantity of received light decreases due to an ambient condition such as mist, oil film or the like, the light reception signal is not capable of exceeding the threshold, and thus an operation error may arise in such state. Consequently, the threshold must be readjusted to comply with the secular change and ambient condition.

An object of the invention is therefore to provide a light identifying system free from the operation error arising due to secular change, ambient condition or other cause.

(Means to Solve the Problem)

The light identifying system according to the invention has a photoelectric conversion unit for receiving a light from the light emitting part on the light receiving part, and generating a light reception signal in magnitude according to a quantity of the received light. Provided further is a peak holding circuit having a time constant large enough as compared with a lighting time interval of the light emitting part, and holding a peak value of the light reception signal inputted therefrom on the time constant. Provided furthermore is a comparator for inputting the peak value held by the peak holding circuit, and comparing it with the light reception signal as a threshold.

In the invention, a peak value of the light reception signal is held, and the peak value thus held is specified as a threshold to the light reception signal, therefore in the unlikely event of decrease in the quantity of emitted light due to a secular change or of decrease in the quantity of received light due to mist, oil film and the like, the threshold decreases accordingly, and thus a light can be identified accurately at all times without an operation error.

The invention will now be described with reference to the accompanying drawings representing one preferred embodiment thereof.

Brief Description of the Drawings

Fig. 1 is a block diagram representing a light identifying system given in one embodiment of the invention;

Fig. 2 is a circuit diagram showing a main part configuration in Fig. 1;

Fig. 3 is a circuit diagram representing another embodiment of the invention;

Fig. 4 is a time chart for illustrating an identifying operation of the invention;

Fig. 5 is a block diagram representing a prior art system.

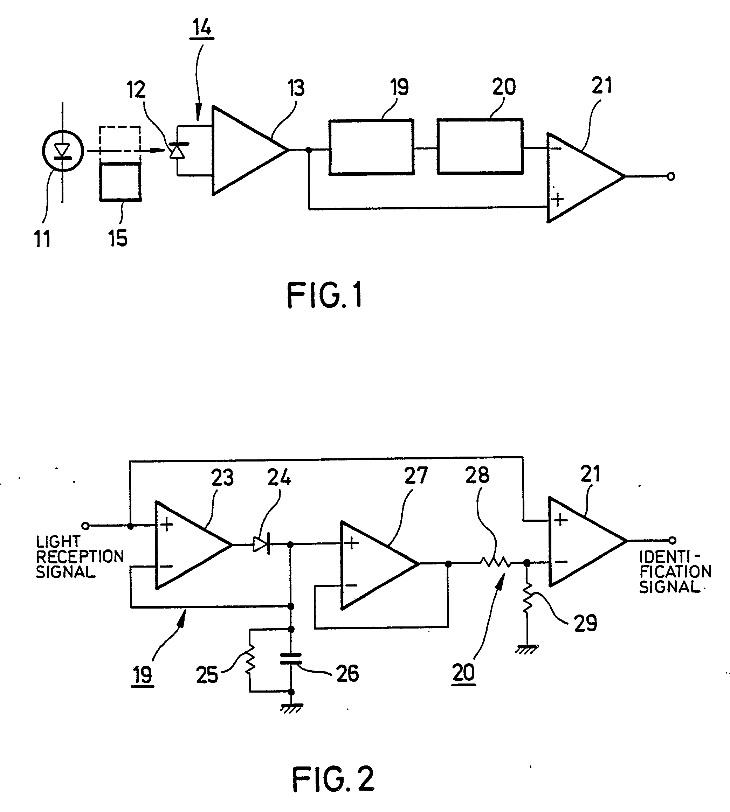

In Fig. 1, the photoelectric conversion unit 14 receives a light from the light emitting part 11 on the light receiving part 12 as ever before, and outputs a light reception signal in magnitude according to a quantity of the received light through the amplifier 13.

A reference numeral 19 denotes a peak holding circuit, which inputs the light reception signal and holds the peak value on a time constant set beforehand. The time constant is set sufficiently large as compared with a lighting time interval of the light emitting part 11. For example, the light emitting part 11 repeats flickering in several 10 $\mu$s to several ms emitting time (or in several kHz to 100 kHz frequency) according to a pulse signal. The time constant is then set sufficiently large at several seconds to several 10 seconds.

A reference numeral 20 denotes a compressing circuit, which compresses the peak value held on the peak holding circuit 19 at a predetermined ratio 1/K.

A reference numeral 21 denotes a comparator, having the light reception signal which is an output of the photoelectric conversion unit 14 inputted to the (+) side input end, and the signal compressed to 1/K by the compressing circuit 20 inputted to the (-) side input end as a threshold.

Fig. 2 shows an example of circuit configuration coming in the peak holding circuit 19, the compressing circuit 20, the comparator 21 shown in Fig. 1. In the drawing, the peak holding circuit 19 comprises an operational amplifier 23, a diode 24 provided on its output end and a time constant setting resistance 25, and a capacitor 26. An output of the peak holding circuit 19 is applied to the compressing circuit 20 through an amplifier 27 working as a buffer. The compressing circuit 20 compresses the output of the peak holding circuit 19 at a dividing ratio by resistances 28, 29, and feeds it to (-) side input end of the operational amplifier 21 constituting the comparator as a threshold. Then, the light reception signal is inputted to (+) side input end of the operational amplifier 21 as described hereinbefore.

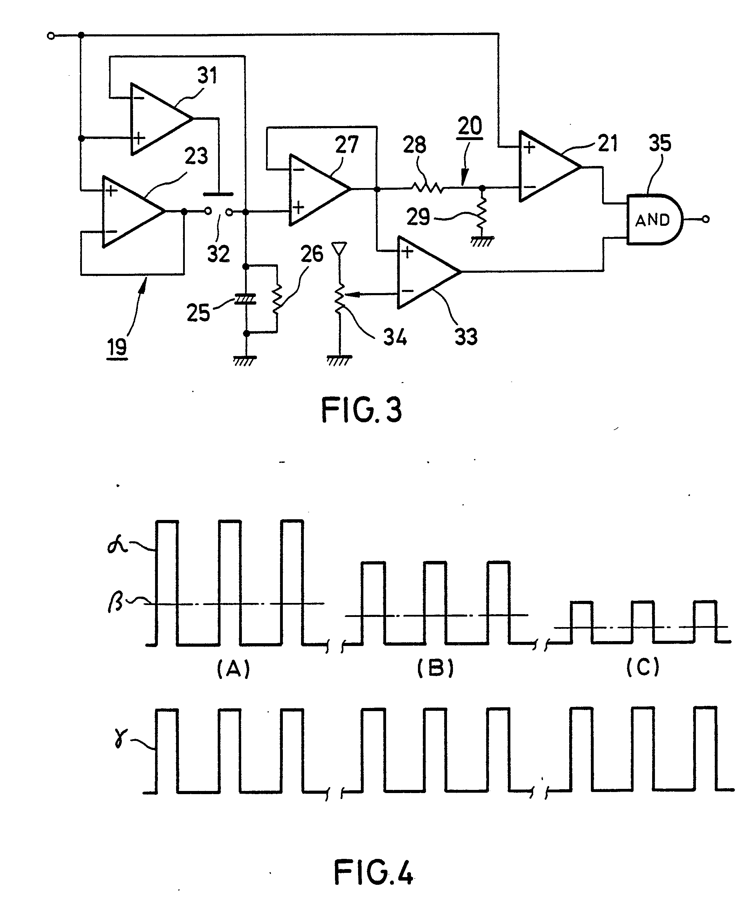

In the aforementioned construction, the light emitting part 11 repeats flickering at a predetermined emitting time as described, and if the object 15 is not present within an interception range, a light of the light emitting part 11 is received on the light receiving part 12, and a light reception signal ($\alpha$ in Fig. 4) in magnitude corresponding to a quantity of the received light. The light reception signal is applied to (+) side input end of the comparator 21, and also has its peak value held on a sufficiently large time constant by the peak holding circuit 19. Further, the peak value thus held is compressed to the predetermined ratio 1/K by the compressing circuit 20, which functions as a threshold ($\beta$ in Fig. 4) of the comparator 21.

Here, since the time constant of the peak holding circuit 19 is sufficiently larger than lighting time interval of the light emitting part 11, the threshold becomes linear in level as indicated by $\beta$ of Fig. 4.

Whenever the light reception signal $\alpha$ exceeds the threshold $\beta$, the output of the comparator 21 comes to an "H" level. Accordingly, an identification signal $\gamma$ synchronized with the light reception signal $\alpha$ is obtainable from the comparator 21.

Now, there may be a case where a magnitude of the light reception signal $\alpha$ changes as, for example, (A), (B) and (C) of Fig. 4 according to secular change, ambient condition and others. Then, since the threshold $\beta$ is a value obtained from compressing the light reception signal $\alpha$ at a predetermined ratio 1/K (1/3 in the example illustrated), the threshold $\beta$ also changes according to change of the light reception signal $\alpha$. Therefore, if the light reception signal $\alpha$ deteriorates due to secular change or other cause, an operation error will never arise.

That is, in case the light reception signal $\alpha$ deteriorates from (A) to (C) in Fig. 4 due to secular change or other cause, if the threshold is fixed on the level 8 of Fig. 4 (A), for example, the light reception signal $\alpha$ in the case of (C) is apparently not capable of exceeding the threshold, the output of the comparator 21 remains on "L" level despite of being not intercepted state, thus causing an operation error.

Meanwhile, the threshold $\beta$ in the invention is a value obtained through holding a peak value of the light reception signal $\alpha$ which is an object for comparison on the large time constant and compressing it at the ratio 1/K, therefore if the object 15 is not for interception and thus a light from the light emitting part 11 reaches the light receiving part 12, the light reception signal $\alpha$ having been deteriorated, if any, due to secular change or other cause is capable of exceeding the coordinating threshold $\beta$ as shown in (A), (B) and (C) of Fig. 4, and the com parator 21 generates the identification signal $\gamma$ changing to "H" level from synchronizing with incoming signals to the light emitting part 11. That is, whether or not the object 15 is present at a predetermined position can definitely be identified on the identification signal γ, and thus an operation error will never be caused unlike hitherto.

Next, in an example of Fig. 3, an analog switch 32 operating on output of another operational amplifier 31 is provided on an output end of the operational amplifier 23 constituting the peak holding circuit 19. Then, in the example, an operational amplifier 33 working as a comparator is further provided, an output of the peak holding circuit 19 through the buffer 27 is impressed to the (+) side input end, a reference voltage set by a resistance 34 is then inputted to (-) side input end, and whether or not the output of the peak holding circuit 19 has exceeded the reference voltage will be identified.

The comparator 33 is intended for detecting whether or not the light reception signal is on a level high enough to separate from a noise component to comparison, and the aforementioned reference voltage is set to a value whereby the level can be decided.

An output of the comparator 33 and an output of the comparator 21 are generated through AND gate 35. That is, if the light reception signal comes below the satisfactory level according to a decision by the comparator 33, then there is a strong possibility that the signal may be erroneous due to noise component, and hence the output of the comparator 21 is locked by AND gate 35 on an "L" level output of the comparator 33. That is, an erroneous operation due to noise component can be prevented.

Then, better comparison and identification will be ensured from adding a known hysteresis characteristic as a comparator.

As described above, according to the invention, if a level of the light reception signal deteriorates due to secular change of the element, readjustment of threshold and others of the comparator is not required unlike hitherto, and moreover, an operation error can be prevented. Further, the system is also capable of following in the wake of a slow change in the working atmosphere due to incoming of mist, dust and the like between the light emitting part and the light receiving part, an operation error will not result still in such case, and a precise detecting operation may be ensured.

enough as compared with a lighting time interval of said light emitting part, and holding a peak value of said light reception signal inputted therefrom on said time constant;

a comparator for inputting the peak value held by the peak holding circuit, and comparing it with said light reception signal as a threshold.

**Claims**

(1) A light identifying system, comprising:
a photoelectric conversion unit for receiving a light from a light emitting part on a light receiving part, and generating a light reception signal in magnitude according to a quantity of the received light;
a peak holding circuit having a time constant large

FIG.1

FIG.2

FIG.3

FIG.4

FIG.5